(19) Europäisches Patentamt
European Patent Office
Office européen des brevets

(11) **EP 3 246 949 A1**

(12) **EUROPEAN PATENT APPLICATION**

(43) Date of publication:
**22.11.2017 Bulletin 2017/47**

(51) Int Cl.:
***H01L 27/146*** (2006.01)    ***G01J 1/04*** (2006.01)

(21) Application number: **17154949.6**

(22) Date of filing: **07.02.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **12.02.2016  US 201662294982 P**

(71) Applicant: **Viavi Solutions Inc.**
**Milpitas, CA 95035 (US)**

(72) Inventor: **Ockenfuss, Georg J.**
**Santa Rosa, CA California 95404 (US)**

(74) Representative: **Murgitroyd & Company**
**165-169 Scotland Street**
**Glasgow G5 8PL (GB)**

(54) **METHOD OF FABRICATING A SENSOR DEVICE**

(57)    According to an example, a first mirror layer may be formed on a substrate. A first set of spacer layers may be deposited on the first mirror layer to be positioned above a first group of the sensing elements and a second set of spacer layers may be deposited on the first mirror layer to be positioned above a second group of the sensing elements, in which the second set of spacer layers differs from the first set. In addition, a second mirror layer may be formed above the deposited first set of spacer layers and the deposited second set of spacer layers.

*FIG. 7B*

**Description**

TECHNICAL FIELD

The technology described herein generally relates to optical sensors, and more particularly relates to method of fabricating a sensor device.

BACKGROUND

Optical sensors are used in a variety of devices, such as image sensors, ambient light sensors, proximity sensors, hue sensors, and UV sensors, to convert optical signals into electrical signals, allowing detection of optical signals or image capture. An optical sensor, generally, includes one or more sensor elements and one or more optical filters situated over the one or more sensor elements. For example, a color image sensor includes an array of color filters, *i.e.*, a color filter array (CFA), that includes different types of color filters having different color pass bands, e.g., red, green, and blue (RGB) filters.

Multispectral imaging is a major goal in many industrial and research applications. In essence, it may be desirable to have a sensor that can simultaneously capture images at wavelengths from many parts of the spectrum (not just limited to the visible, but including the near-, mid- and longwave infrared and/or ultraviolet), without needing to carry out a scan or a sequence of exposures that then have to be recombined with one another with appropriate weightings to produce a useful image. Multispectral imaging is described in, for example, "Multispectral Filter Arrays: Recent Advances and Practical Implementation", Lapray et al., Sensors, 14:21626 - 21659, (2014), incorporated herein by reference.

Hyperspectral imaging is also becoming important: in hyperspectral imaging, the goal is to capture a spectrum of data for each pixel in an image, where the spectrum has fine resolution.

Although color filters based on dyes have been used, they have been found to produce less brilliant colors than interference-based filters formed from stacked dielectric layers. Dielectric color filters have higher transmission levels and narrower color passbands, but may give rise to undesirable shifts in color (wavelength) with changes in incident angle.

A narrow bandpass filter is one in which the bandwidth is 20% or less of the center wavelength. It has been found that combining a narrow bandpass filter with a standard photo diode results in poor transmission and a large variation of photopic values.

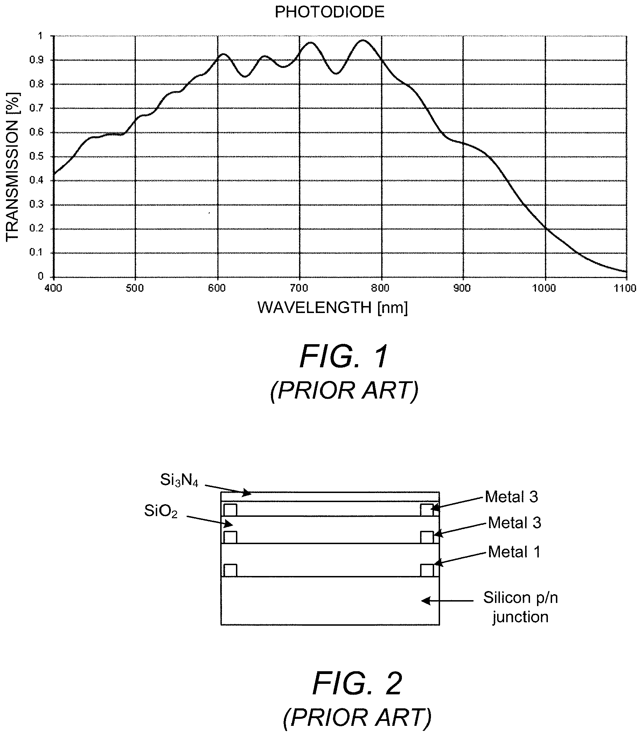

Typical quantum efficiency (QE) curves of photodiodes look like the curve shown in FIG. 1. What is actually not immediately apparent from this representation is that it is based on the light being collected over a wide angle range, as well as with limited spectral resolution, so it does not reveal the other drawback, which is caused by the interference effects of the underlying structure.

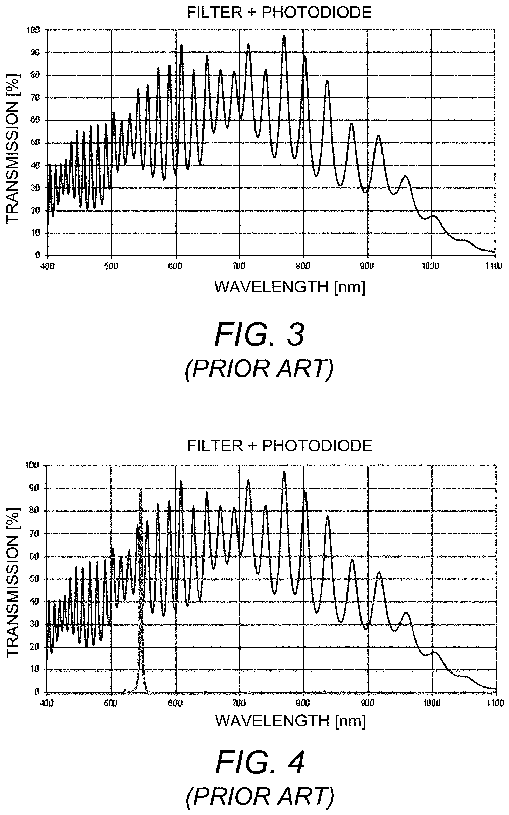

The structure of a typical photo-diode is shown in FIG. 2. In such a diode, the thin dielectric layers ($SiO_2$ and $Si_3N_4$ as shown), on top of the p/n junction, create interference effects. When illuminating the diode with collimated light that has a narrow spectral resolution, the quantum efficiency curve looks like the graph in FIG. 3. Conversely, when broadening the spectral resolution and increasing the acceptance angle, the curve in FIG. 3 converts to the curve in FIG. 1. This is due to two effects: a) an averaging that occurs when lowering the spectral resolution; and b) a wavelength-shift of the spectral response with angle.

If a typical diode is used with a broad-band light source, or with broad-band filters (e.g., dye based color filters), or at large acceptance angles, the principal drawback is a lower overall transmission level. This can be compensated for by using larger diodes. However, increasing the size of the diode is not always the most desirable solution.

Recently, the industry has been looking into combining photodiodes with optical filter functions, such as narrow bandpass filters, which promote higher spectral resolution. Using these filters requires in many cases a reduction of the acceptance angles due to the angle shift of the optical filters; *i.e.*, the sensor is illuminated with close to collimated light. FIG. 4 shows an overlay of the transmission curve for a narrow bandpass filter (at approx. 540 nm) with the response of a standard photodiode, such as shown in FIG. 3.

Depending on the location in the spectrum, the total throughput in the passband can vary by more than a factor of 2. (For example, if the bandpass filter transmits at 900 nm, the throughput is only 30%, where a filter transmitting at 770 nm may see an almost 100% transmittal.) Another drawback is that the locations of the ripples in the transmission curve of the photodiode are not well controlled. Thus, there can be a large variation of the photopic value from one device to another, because the spectral placement of the ripples may vary as a result of minor manufacturing inconsistencies or compositions of the materials.

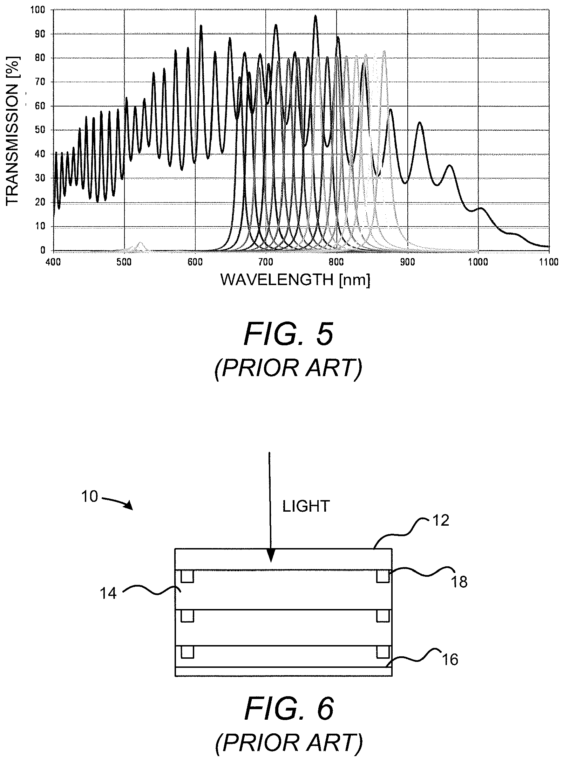

These drawbacks become heightened when multiple filters are involved, as is the case in a multi spectral sensor array based on, for example, a binomial filter structure. An example is shown in FIG. 5 for a number of bandpass filters transmitting at a sequence of wavelengths, superimposed on the same photo-diode transmission curve as shown in FIGS. 3 and 4. The overall transmission at a given bandpass filter wavelength varies dramatically from one wavelength to the next, depending on how the peaks align with the ripples in the photodiode transmission spectrum.

Accordingly, there is a need for a device that combines one or more bandpass filters in such a way that the angular variation and variation of transmission with wavelength are as smooth as possible, and offers a large spectral range.

The discussion of the background herein is included to explain the context of the technology. This is not to be taken as an admission that any of the material referred to was published, known, or part of the common general knowledge as at the priority date of any of the claims found appended hereto.

Throughout the description and claims of the application the word "comprise" and variations thereof, such as "comprising" and "comprises", is not intended to exclude other additives, components, integers or steps.

## BRIEF DESCRIPTION OF THE DRAWINGS

Features of the present disclosure are illustrated by way of example and not limited in the following figure(s), in which like numerals indicate like elements, in which:

FIG. 1 shows a conventional transmission or quantum efficiency (QE) curve of a silicon based photodiode.

FIG. 2 shows a conventional structure of a standard photo diode.

FIG. 3 shows the QE of a conventional photodiode illuminated with collimated light and with high spectral resolution.

FIG. 4 shows the QE of a conventional photodiode illuminated with collimated light and with high spectral resolution, in conjunction with a single narrow bandpass filter.

FIG. 5 shows the QE of a conventional photodiode illuminated with collimated light and with high spectral resolution, in conjunction with a set of narrow bandpass filters having different characteristic wavelengths.

Fig. 6 shows a conventional structure of a back illuminated sensor (BIS).

FIGS. 7A and 7B, respectively show a cross-sectional top view and a cross-sectional side view of a sensor device in accordance with an example of the present disclosure.

FIGS. 8A-8E collectively show an example method of fabricating the sensor device depicted in FIGS. 7A and 7B.

FIG. 8F shows an example method of fabricating a sensor device according to another example of the present disclosure.

FIG. 9A depicts a top view of the configuration shown in FIG. 8C.

FIG. 9B shows an enlarged cross-sectional side view of a portion of the configuration shown in FIG. 8C.

FIG. 10 depicts a top view of the configuration shown in FIG. 8D.

FIG. 11 depicts an example structure for a binary filter, which may represent a portion of the sensor device depicted in FIGS. 7A and 7B, according to an example of the present disclosure.

FIGS. 12A-12C respectively show example filter arrays based on a binary filter structure, according to an example of the present disclosure.

FIGS. 13A and 13B respectively show example filter arrays based on a binary filter structure, according to another example of the present disclosure.

FIG. 14 shows an example structure, shown in cross-section, for a binary filter using dielectric reflectors/mirrors, which may represent a portion of the sensor device depicted in FIGS. 7A and 7B, according to an example of the present disclosure.

FIG. 15 shows example structures, shown in cross-section, for a binary filter using metal reflectors/mirrors, which may represent a portion of the sensor device depicted in FIGS. 7A and 7B, according to an example of the present disclosure.

FIG. 16 shows a spectral response of the structures depicted in FIG. 15, according to an example of the present disclosure.

FIG. 17 shows an enlarged diagram of an 8x8 filter array that may be fabricated through implementation of the methods disclosed herein.

DETAILED DESCRIPTION

For simplicity and illustrative purposes, the present disclosure is described by referring mainly to an example thereof. In the following description, numerous specific details are set forth in order to provide a thorough understanding of the present disclosure. It will be readily apparent however, that the present disclosure may be practiced without limitation to these specific details. In other instances, some methods and structures have not been described in detail so as not to unnecessarily obscure the present disclosure. As used herein, the terms "a" and "an" are intended to denote at least one of a particular element, the term "includes" means includes but not limited to, the term "including" means including but not limited to, and the term "based on" means based at least in part on. The terms "first" and "second" as used herein are not intended to denote any particular order or placement of an element. Instead, these terms are used herein to denote that one element differs from another element. As used herein, the terms "approximately" and "about" indicate a range of values within +/- 5% of a stated value.

Additionally, it should be understood that the elements depicted in the accompanying figures may include additional components and that some of the components described in those figures may be removed and/or modified without departing from scopes of the elements disclosed herein. It should also be understood that the elements depicted in the figures may not be drawn to scale and thus, the elements may have different sizes and/or configurations other than as shown in the figures.

Disclosed herein is a method of fabricating sensor devices having optical filters that may be used in conjunction with back illuminated sensors. Devices having optical filters in conjunction with back illuminated sensors will have application to many types of sensor, particularly those used in multi- and hyper- spectral imaging and sensing. As used herein, reflectors and mirrors or mirrored layers, are used interchangeably.

One way to avoid the shortcomings of the combinations of photo diodes and bandpass filters of the known devices is to use a back illuminated sensor (BIS), and/or to combine the combinations of photo diodes and bandpass filters with optical structures such as FP filters. BIS 10, as shown in FIG. 6, may include a silicon p/n junction layer 12. The p/n junction 12 may be formed from dopants in the silicon, close to the interface with the silicon p/n junction layer 12. A stack of dielectric layers 14, which may be formed of $SiO_2$, may be formed on one side of the silicon p/n junction layer 12. In addition, another dielectric layer 16, which may be $Si_3N_4$, may be formed on an opposite side of the stack of dielectric layers 14. Metal contact layers 18 may be situated within the layers of the stack of dielectric layers 14. Light may enter the BIS 10 into the silicon p/n junction layer 12 without first passing through any of the dielectric layers 14, 16. The thickness of the stack of dielectric layers 14 may be adjusted according to the light that is desired to pass through the BIS 10. This means that, when combining with a bandpass function, it may only be necessary to match the optical filter frequency to the refractive index profile of the "substrate" medium 12, which may be silicon. Thus, interference artefacts that typically arise from the light passing through dielectric layers such as oxide and nitride are non-existent with this approach.

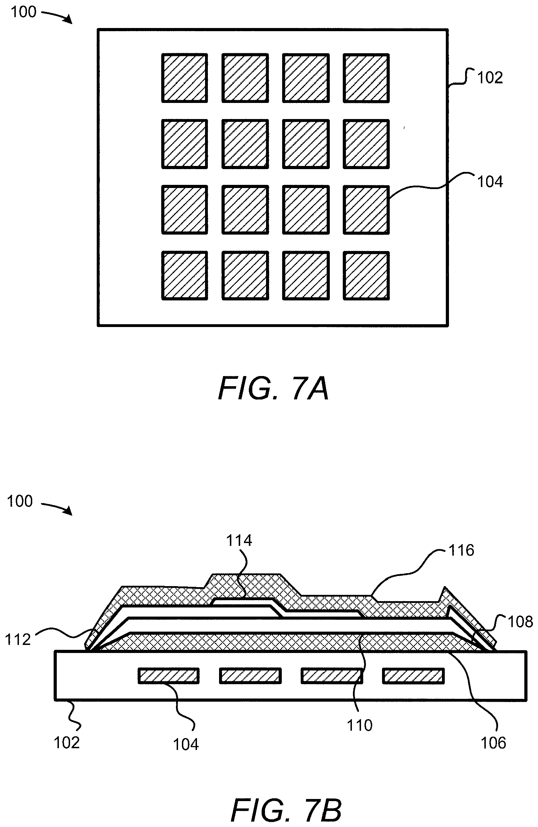

With reference now to FIGS. 7A and 7B, there are respectively shown a cross-sectional top view and a cross-sectional side view of a sensor device 100 in accordance with an example of the present disclosure. The sensor device 100 is depicted as including a substrate 102 and a plurality of sensing elements 104. The substrate 102 may be formed of a passive material, such as silicon, glass, or the like. One or more of the sensing elements 104 may be a photodiode, a complementary metal-oxide semiconductor (CMOS), a charge-coupled device (CCD), or the like. For purposes of simplicity and convenience, the sensor device 100 is depicted as including a 4x4 array of sensing elements 104. It should, however, be clearly understood that the sensor device 100 may include any number of sensing elements 104.

As shown in FIG. 7B, the sensor device 100 may include a first mirror layer 106 formed on one side of the substrate 102 such that the first mirror layer 106 extends over each of the sensing elements 104. The sensor device 100 may also include a base spacer layer 110, a first spacer layer 112, a second spacer layer 114, and a second mirror layer 116. Although not shown, the sensor device 100 may include additional spacer layers positioned above various ones of the sensing elements 104 and between the first mirror layer 106 and the second mirror layer 116. Various manners in which the sensor device 100 may be fabricated are described with respect to the following figures.

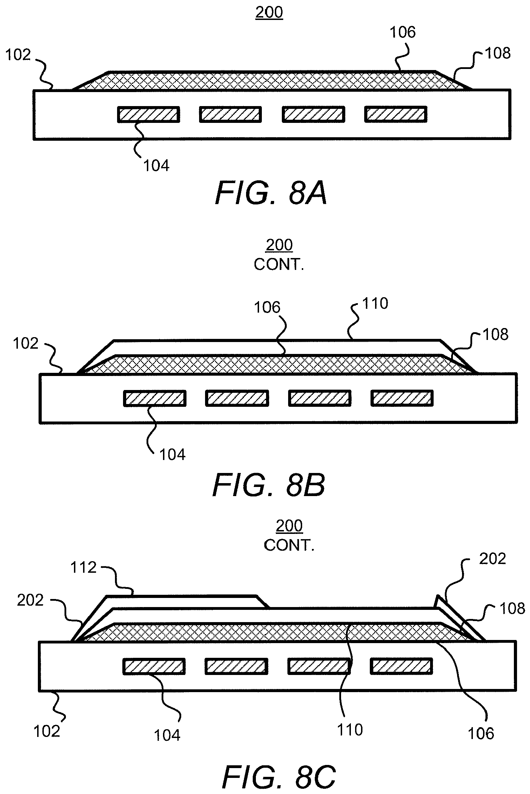

Turning now to FIGS. 8A-8E, there are collectively shown an example method 200 of fabricating the sensor device 100 depicted in FIGS. 7A and 7B. As shown in FIG. 8A, a first mirror layer 106 is formed on a substrate 102, in which the substrate 102 includes an array of sensing elements 104. The first mirror layer 106 may be formed of a metallic material such as silver, aluminum, copper, gold, or the like. In this example, the first mirror layer 106 may be formed via a metal deposition process such as, magnetron sputtering, electron beam epitaxy, molecular beam epitaxy, thermal evaporation, atomic layer deposition, or the like. The first mirror layer 106 may be formed with tapered edges 108 due to the deposition process and a lift-off process. That is, each of the edges of the first mirror layer 106 may be tapered due to a combination of the deposition process and a lift-off process, e.g., a photo-resist having an overhang may be used during the deposition and lift-off processes, which may produce the tapered edges 108. By way of particular example, the first mirror layer 106 may be formed to have a ZnO/Ag/ZnO structure, in which the ZnO thickness is between about 0.5 nm to about 4 nm. In other example, the ZnO thickness may be between about 1 nm to about 2 nm.

In other examples, the first mirror layer 106 may be formed of a dielectric material such as $SiO_2$, $NbO_2$, or the like. In further examples, the first mirror layer 106 may be formed of quarter-wave stacks, for instance, of $SiO_2$ and Si:H layers. In still further examples, the first mirror layer 106 may be formed of oxides, nitrides, Ge, Si, Si:H, SiC, or the like. Examples of suitable oxides include high index: $Nb_2O_5$ $Ta_2O_5$, $TiO_2$, $HfO_2$, and mixtures thereof and low index: $SiO_2$, $Al_2O_3$, and mixtures thereof. Examples of suitable nitrides include high index: $Si_3N_4$, Ge, Si, Si:H, and SiC. According to an example for a near infrared (NIR) filter, the first mirror layer 106 is formed of Si:H or $SiO_2$. In these examples, the first mirror layer 106 may not be formed with the tapered edges.

As shown in FIG. 8B, a base spacer layer 110 may be deposited on the first mirror layer 106 to cover the first mirror layer 106, including the tapered edges 108, if present. The base spacer layer 110 may be formed of materials such as oxides, nitrides, Ge, Si, Si:H, SiC, SiGe, SiGe:H or the like. For instance, the base spacer layer 110 may be formed of the same or similar materials as those discussed above with respect to the first mirror layer 106. According to an example for a near infrared (NIR) filter, the base spacer layer 110 is formed of Si:H. In addition or alternatively, the base spacer layer 110 may be deposited during formation of the first mirror layer 106, e.g., in a common vacuum as the first mirror layer 106.

The base spacer layer 110 may be deposited through performance of a suitable deposition process including any of chemical vapor deposition, physical vapor deposition, plasma-enhanced chemical vapor deposition, and the like. In a particular example, the base spacer layer 110 may be deposited using a lift-off process. In addition, deposition of the base spacer layer 110 may cause portions of the base spacer layer 110 to cover the tapered edges 108 of the first mirror layer 106. The base spacer layer 110 may be deposited to cover the tapered edges 108 of the first mirror layer 106 to protect the tapered edges 108 from oxidization, for example, in instances in which the first mirror layer 106 is formed of silver. However, in instances in which the first mirror layer 106 is formed of materials other than metals, the base spacer layer 110 may be deposited without covering the tapered edges 108. In addition, although not shown in FIG. 8B, the base spacer layer 110 may include materials that perform additional filter functions such as anti-reflection, blocking, higher-order suppression filtering, or the like. By way of example, an oxidizing preventing material layer, such as a layer of zinc oxide (ZnO), may be provided below and above the first mirror layer 106 to further prevent the first mirror layer 106 from oxidizing.

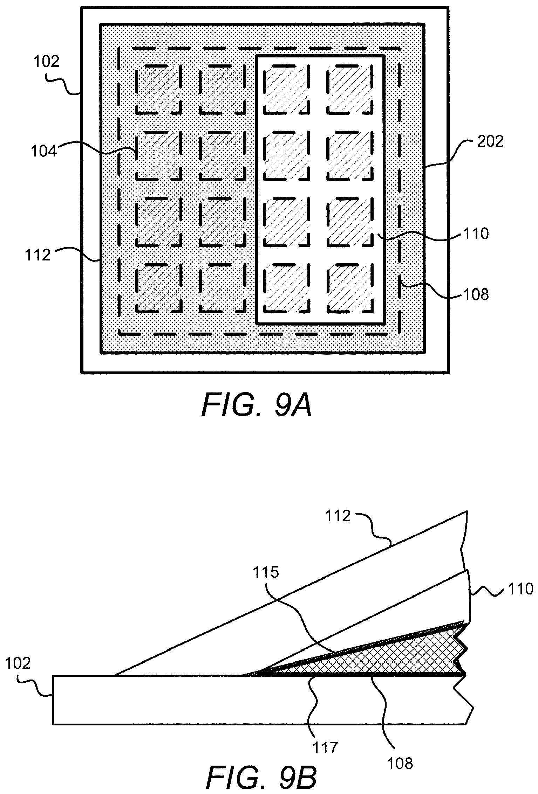

As shown in FIG. 8C, a first spacer layer 112 may be deposited above a first group of sensing elements 104. For instance, and as shown in FIG. 8C, the first spacer layer 112 may be deposited on the base spacer layer 110 above the eight sensing elements 104 located on the left side of the substrate 102. This example is also shown in FIG. 9A, which depicts a top view of the configuration shown in FIG. 8C. Additionally, as shown in FIGS. 8C and 9A, the first spacer layer 112 may also be deposited to cover the tapered edges 108 of the first mirror layer 106. In this regard, following deposition of the first spacer layer 112, the portions of the base spacer layer 110 that are above the eight sensing elements 104 located on the right side of the substrate 102 may be uncovered by the first spacer layer 112, while the tapered edges 108 around the first mirror layer 106 are covered, as indicated by element 202. An enlarged cross-sectional side view of a portion of the configuration shown in FIG. 8C is depicted in FIG. 9B. As shown in FIG. 9B, the tapered edge 108 may be covered by a portion of the first spacer layer 110. However, the portion of the first spacer layer 110 that covers the tapered edge 108 may not provide sufficient protection to the tapered edge 108. In this regard, a portion of the second spacer layer 112 may also be provided over the tapered edge 108. In addition, the top and the bottom of the tapered edge 108, as well as the remainder of the first mirror layer 106, may be covered by respective layers 115, 117 of oxidation preventing material, for instance, ZnO. The second mirror layer 116 may be similarly protected with the oxidation preventing material.

The first spacer layer 112 may be deposited through implementation of similar deposition techniques as those discussed above with respect to the deposition of the base spacer layer 110. In addition, a mask (not shown) may be applied over the sections of the base spacer layer 110 that are not to receive the first spacer layer 112 during the deposition process to prevent the first spacer layer 112 from being deposited onto those sections. The mask may be removed following deposition of the first spacer layer 112. According to an example, the mask may include a photoresist.

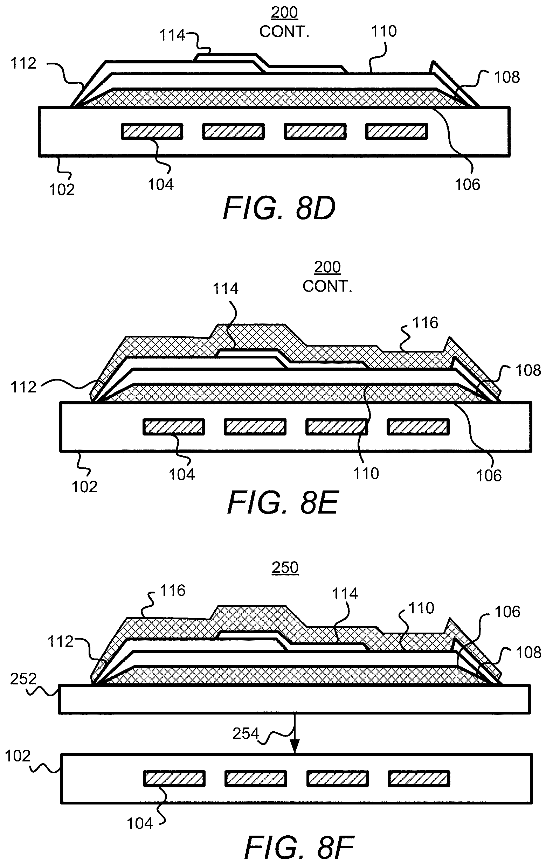

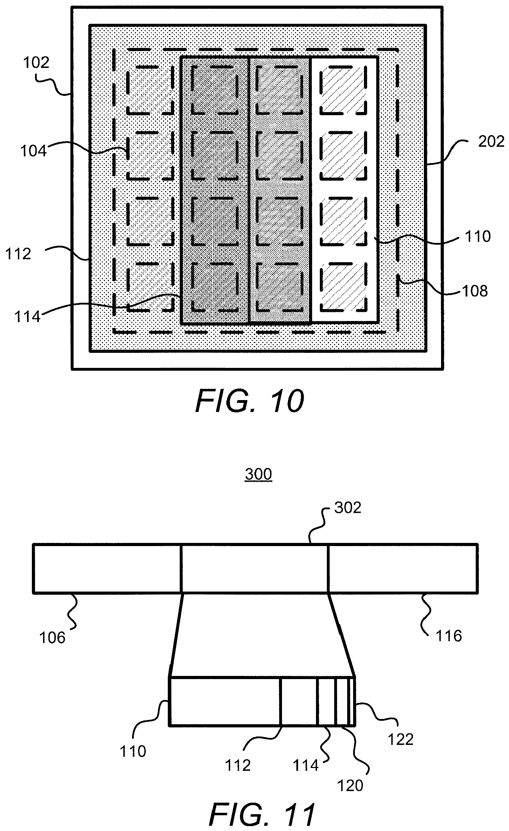

As shown in FIG. 8D, a second spacer layer 114 may be deposited above a second group of sensing elements 104. For instance, and as shown in FIG. 8D, the second spacer layer 114 may be deposited on part of the base spacer layer 110 above the four sensing elements 104 located on the middle-right side of the substrate 102 and on part of the first spacer layer 112 above the four sensing elements 104 located on the middle-left side of the substrate 102. This example is also shown in FIG. 10, which depicts a top view of the configuration shown in FIG. 8D. As shown in FIGS. 8D and 10, the heights or thicknesses of the spacer layers 110-114 above respective ones of the sensing elements 104 may differ for different groups of the sensing elements 104. In this regard, different center wavelengths of light may be filtered prior to reaching the different groups of the sensing elements 104. In some examples, the second spacer layer 114 may be deposited above half the sensing elements 104 as compared with the sensing elements 105 upon which the first spacer layer 112 was deposited. Similarly, each subsequent spacer layer may deposited above half the sensing elements 104 as the previous spacer layer.

As also shown in FIG. 8D, each of the spacer layers 110-114 may have different heights (or thicknesses) with respect to each other. For instance, the base spacer layer 110 may be thicker than the first spacer layer 112 and the first spacer layer 112 may be thicker than the second spacer layer 114. In addition, subsequently deposited spacer layers (not shown), if deposited, may have increasingly smaller thicknesses.

The second spacer layer 114 may be deposited through implementation of similar deposition techniques as those discussed above with respect to the deposition of the base spacer layer 110. In addition, a mask (not shown) may be applied over the sections of the base spacer layer 110 and the first spacer layer 112 that are not to receive the second spacer layer 114 during the deposition process to prevent the second spacer layer 114 from being deposited onto those sections. The mask may be removed following deposition of the second spacer layer 114.

Although not shown in FIGS. 8D and 10, during deposition of the second spacer layer 114, the areas above the tapered edges 108 of the first mirror layer 106 may be further covered by the second spacer layer 114. In this example, the second spacer layer 114 may be deposited over the tapered edges 108 of the first mirror layer 106 and on top of the portions 202 of the first spacer layer 112 that cover the tapered edges 108.

As shown in FIG. 8E, a second mirror layer 116 may be formed above the deposited spacer layers 110-114. The second mirror layer 116 may be formed of a metallic material such as silver, aluminum, or the like. In other examples, the second mirror layer 116 may be formed of a dielectric material such as $SiO_2$, $NbO_2$, or the like. In still other examples, the second mirror layer 116 may be formed of quarter-wave stacks, for instance, of $SiO_2$ and Si:H layers. In addition, the second mirror layer 116 may be formed in any of the manners discussed above with respect to formation of the first mirror layer 106. Deposition of the second mirror layer 116 may also include the addition of materials that may perform extra filter functions such as anti-reflection, out of band blocking, higher-order suppression filtering, or the like.

Following deposition of the second mirror layer 116, additional processing may be performed, such as, the addition of micro lenses (not shown) to the second mirror layer 116.

Although the method 200 of fabricating the sensor device 100 has been described as including two spacer layers 112 and 114, it should be understood that the method 200 may include additional spacer layer deposition steps. By way of particular example, the method 200 may include six spacer layer deposition steps such that many different filter structures may be fabricated over the sensing elements 104.

Turning now to FIG. 8F, there is shown an example of a method of fabricating the sensor device 100 according to another example. FIG. 8F includes many of the same features as those discussed above with respect to FIGS. 8A-8E and thus, those common features are not described in detail with respect to FIG. 8F. However, the example shown in FIG. 8F differs from the example shown in FIG. 8E in that the mirror layers 106, 116 and the spacer layers 110-114 are formed on a substrate 252 that may not include sensing elements. That is, instead of being formed on the substrate 102, which includes an array of sensing elements 104, the example in FIG. 8F shows that the mirror layers 106, 116 and the spacer layers 110-114 maybe formed on a separate substrate 252, which may be a glass wafer. In addition, the substrate 252 may be adhered to the substrate 102, which may be a sensor array, as indicated by the arrow 254. By way of example, the substrate 252 may be adhered to the substrate 102 through use of an epoxy and more particularly, a transparent epoxy.

According to an example, the sensor device 100 may be a single cavity Fabry-Perot filter. In addition, the center wavelengths of light that are filtered by the filter may vary depending the thickness of the spacer in the cavity. An example in which additional spacer layers may be provided between the first mirror layer 106 and the second mirror layer 116 is shown in FIG. 11. Particularly, FIG. 11 depicts an example structure 300 for a binary filter, for instance, a single cavity Fabry-Perot filter, which may represent a portion of the sensor device 100, e.g., a portion above a particular sensing element 104, according to an example. As shown in FIG. 11, a cavity 302 is provided between the first mirror layer 106 and the second mirror layer 116. In addition, the structure 300 shows the relationship between the size of the spacer layers in the cavity 302 and the channel (e.g., center wavelength) that is filtered by the spacer layers. It has been observed that relatively small differences in spacer thickness may result in a significant separation of center wavelengths between otherwise identical filters.

For instance, if the cavity 302 is provided with the base spacer layer 110 without the other spacer layers, the filter may filter the $0^{th}$ channel, e.g., the filter may filter light having a first center wavelength. Likewise, if the cavity 302 is provided with both the spacer layer 110 and the first spacer layer 112, the filter may filter the $8^{th}$ channel. As another example, if the cavity 302 is provided with the base spacer layer 110, the first spacer layer 112, and the second spacer layer 114, the filter may filter the $4^{th}$ channel. As a further example, if the cavity 302 is provided with the base spacer layer 110, the first spacer layer 112, the second spacer layer 114, and a third spacer layer 120, the filter may filter the $2^{nd}$ channel. As a yet further example, if the cavity 302 is provided with the base spacer layer 110, the first spacer layer 112, the second spacer layer 114, the third spacer layer 120, and a fourth spacer layer 122, the filter may filter the 1st channel.

According to an example, prior to implementation of the method 200, a determination may be made as to how the filters are to be configured for each of the sensing elements 104. That is, the channels (e.g., center wavelengths of light) that the filters are to filter for each of the sensing elements 104 may be determined. In addition, based upon the correlation between the filtering of the channels and the thicknesses of the spacer layer in the cavity 302, the corresponding arrangement of the spacer layer depositions over the respective sensing elements 104 may be determined. For example, a determination may be made that a first group of sensing elements 104, which may be a single sensing element, is to filter the 4th channel. In this example, a determination may be made that the base spacer layer 110, the first spacer layer 112, and the second spacer layer 114 are to be deposited over the first group of sensing elements 104. In addition, a determination may be made that a second group of sensing elements 104, which may also be a single sensing element, is to filter the 8th channel. In this example, a determination may be made that the base spacer layer 110 and the first spacer layer 112 are to be deposited over the second group of sensing elements 104.

According to an example, the number of coating runs, e.g., the number of spacer layers that are to be deposited for a filter array based on a binary filter structure may be calculated using either of the following equations:

$$\text{Equation (1):} \qquad c = 2^{(n_{coat} - 2 - b)}$$

$$\text{Equation (2):} \qquad n_{coat} = log_2(c) + 2 + b$$

In Equations (1) and (2), "c" represents the channel number, "$n_{coat}$" represents the number of coating runs, and "b" represents the number of additional AR coatings or blockers for higher order suppression. The additional blockers are described in greater detail herein below.

The following table illustrates examples of the number of coating runs and blockers used for different channel numbers.

| Channel Number | Coating Runs | Blocker |
|---|---|---|
| 16 | 6 | 0 |
| 32 | 7 | 0 |
| 64 | 9 | 1 |
| 128 | 10 | 1 |
| 128 | 9 | 0 |

According to an example, the coating thickness of a binary spacer layer, e.g., spacer layers 110-122, may be calculated using the following equations:

$$\text{Equation (3):} \qquad t_0 = t_{min}$$

$$\text{Equation (4):} \qquad t_1 = \frac{c/2}{(c-1) \cdot 2 \cdot n_{ref}} \cdot (\lambda_{max} - \lambda_{min})$$

$$\text{Equation (5):} \qquad t_2 = \frac{t_1}{2} \dots t_n = \frac{t_{n-1}}{2}, \text{ with } n = log_2(c)$$

In Equations (3)-(5), "c" is the channel number, "$t_0$" is the thickness of the base spacer layer 110, "$t_1$" is the thickness of the first spacer layer 112, and "$t_n$" is the thickness of the last spacer layer 122. In addition, "$\lambda_{min}$" is the lowest center wavelength, "$\lambda_{max}$" is the highest center wavelength, and "$n_{ref}$" is the refractive index of the spacer layer.

Any number of channels may be realized through implementation of the methods disclosed herein. For instance, the methods disclosed herein may be used for 100 channels, although the same number of coating runs for 128 channels would be required. As another example, the methods disclosed herein may be used for 50 channels, although the same number of coating runs for 64 channels would be required.

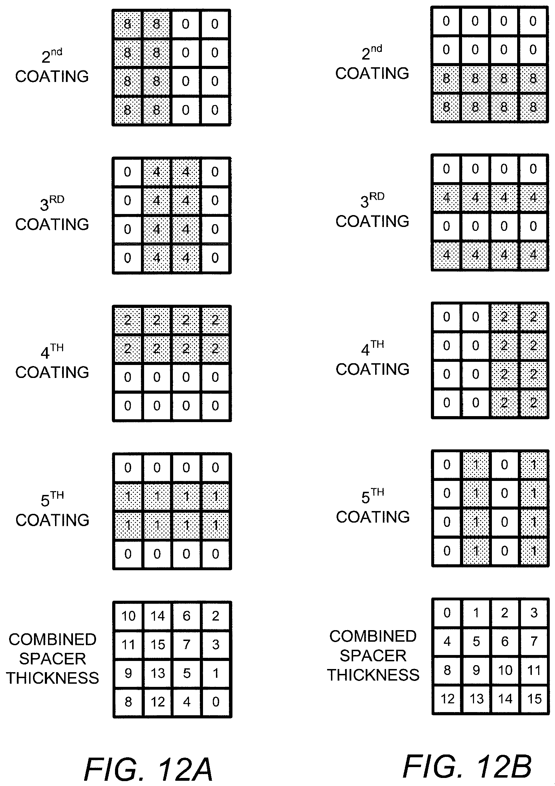

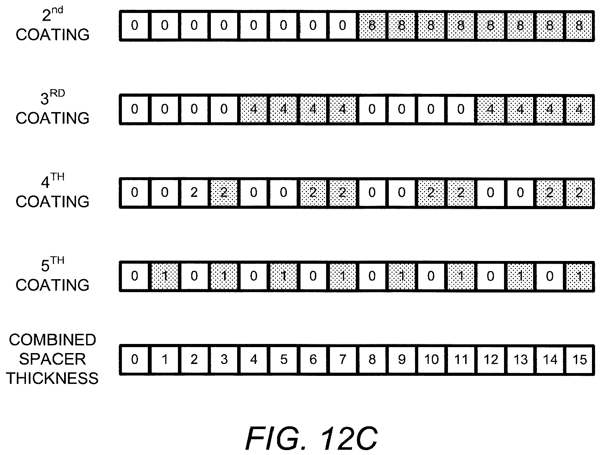

Turning now to FIGS. 12A-12C, there are shown example filter arrays based on a binary filter structure. More particularly, each of FIGS. 12A-12C depicts the thickness of a spacer layer, as a multiple of a unit thickness, deposited during each of several coating runs. In each of the examples, the spacer layers are shown as initially being deposited during a second coating run because the first coating run may include the deposition of the base spacer layer. As shown in FIGS. 12A-12C, the thicknesses of the respective spacer layers vary by a binary number. That is, the thickness of each of the spacer layers decreases by a factor of two during each of the coating runs. In one regard, filter arrays depicted in FIGS. 12A-12C have equidistant channel spacing. In addition, the thicknesses of the spacer layers may be determined through Equations (3)-(5) discussed above.

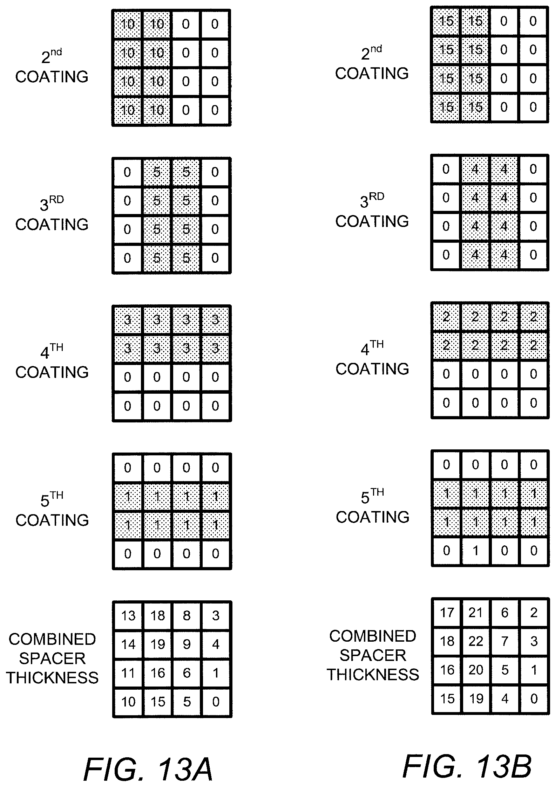

Additionally or alternatively, however, the thickness of each of the spacer layers may vary by different factors. In these examples, the filter array may have a binary filter structure with non-equidistant channel spacing. Two examples of these types of 16 channel filter arrays are shown in FIGS. 13A and 13B. These types of filter arrays may be employed when channels may be skipped, which may result in the non-equidistant channel spacing. In addition, Equations (4)-(5) may not be applied to determine the thicknesses of the spacer layers in these examples. However, the calculations for $t_0=t_{min}$, $t_{min}$, and $t_{max}$ may still apply.

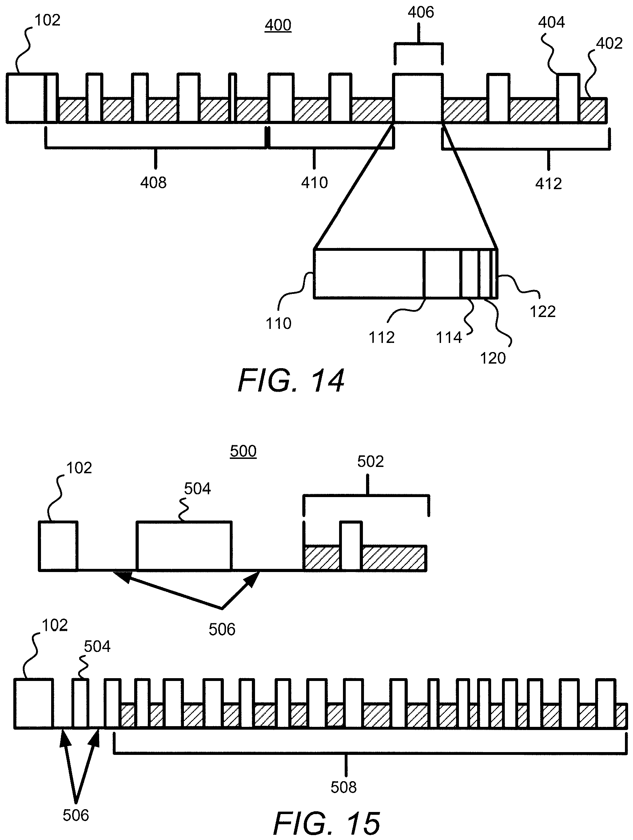

Turning now to FIG. 14, there is shown an example structure 400, shown in cross-section, for a binary filter using dielectric reflectors/mirrors, which may represent a portion of the sensor device 100, e.g., a portion above a particular sensing element 104, according to an example. As shown in FIG. 14, the structure 400 may be formed of alternating layers of materials, for instance, $SiO_2$ 402 and Si:H 404 on a substrate 102. By way of particular example, a spacer 406 may have a minimum thickness of 108.5 nm and may be made up of up to 6 spacer layers. Together, groups of the layers function as visible blockers 408 and reflectors 410, 412. For instance, the layers 402 and 404 in a reflector 410 may be quarter wave stacks, i.e., form a reflector at that wavelength. Likewise, the layers 402 and 404 in a reflector 412 may also be quarter wave stacks. In these examples, the total thickness of the structure may be in the range of about 1732 nm to about 1782.5 nm. For instance, the visible blockers 408 and the reflectors 410, 412 may each have a thickness of about 1160 nm. In addition, the base spacer layer 110 may have a thickness of between about 80 nm to about 130 nm, the first spacer layer 112 may have a thickness of between about 10 nm to about 50 nm, the second spacer layer 114 may have a thickness of between about 5 nm to about 25 nm, the third spacer layer 120 may have a thickness of between about 2.5 nm to about 13 nm, and the fourth spacer layer 122 may have a thickness of between about 1.5 nm to about 7 nm. The thinnest thickness that a layer may have may be less than 1 nm, for instance, about 0.6 nm in the case of 128 channels.

Turning now to FIG. 15, there are shown example structures 500, shown in cross-section, for a binary filter using metal reflectors/mirrors, which may represent a portion of the sensor device 100, e.g., a portion above a particular sensing element 104, according to an example. The structures 500 may include an Ag based single-cavity Fabry-Perot functioning in UV-Vis-NIR. The upper structure shows a portion of a filter for UV-green channels and the lower structure shows a portion of a filter for green-NIR channels. The filter for UV-green channels is depicted as including an anti-reflective (AR) coating 502, which may be formed of NbTiOx, $SiO_2$, or the like. By way of example, the AR coating 502 may have a thickness of about 140 nm. In addition, the AR coating 502 may protect the mirror layer as well as provide anti-reflection properties.

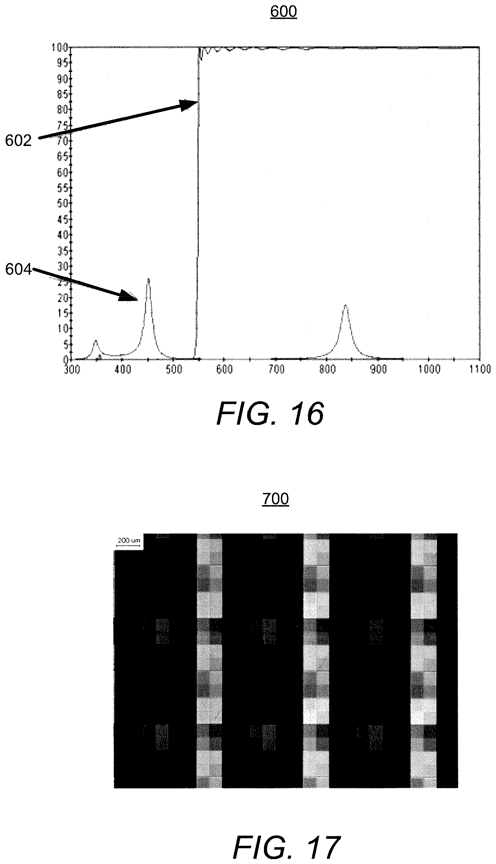

The lower structure shows a portion of a filter for green-NIR channels. Each of the structures 500 may include a first order spacer 504, which may be similar to the spacer 406 depicted in FIG. 14. The spacer 504 may be up to around 150 nm thin and may be sandwiched between two mirror layers 506, which may be around 45 nm thick and may be formed of Ag. The lower structure may also include a UV-green blocker 508, which may be around 3000 nm thick and may be composed of alternating layers of NbTiOx and $SiO_2$. The blocker 508 may suppress higher order peaks as discussed in greater detail herein below with respect to FIG. 16.

FIG. 16 shows a spectral response of the structures 500 depicted in FIG. 15, according to an example. As shown in that figure, the blocker 508 suppresses higher order peaks at lower wavelengths. The blocker 508 may be implemented when a large spectral bandwidth is to be covered. In the example depicted in FIG. 16, light is to be transmitted at 850 nm, which may require the addition of a longwave pass that blocks the higher order peaks at 350 nm and 450 nm. The blocker is depicted in FIG. 16 as reference numeral 602. Additionally, the spectral response of the Fabry-Perot filter made from the substrate 102, the first and second mirror layer 506, and the spacer 504 is depicted in FIG. 16 as reference numeral 604.

With reference now to FIG. 17, there is shown an enlarged diagram of an 8x8 filter array that may be fabricated through implementation of the methods disclosed herein. As shown in that figure, a pattern is repeated every 8 pixels.

Although described specifically throughout the entirety of the instant disclosure, representative examples of the present disclosure have utility over a wide range of applications, and the above discussion is not intended and should not be construed to be limiting, but is offered as an illustrative discussion of aspects of the disclosure.

What has been described and illustrated herein is an example of the disclosure along with some of its variations.

The terms, descriptions and figures used herein are set forth by way of illustration only and are not meant as limitations. Many variations are possible within the spirit and scope of the disclosure, which is intended to be defined by the following claims -- and their equivalents -- in which all terms are meant in their broadest reasonable sense unless otherwise indicated.

**Claims**

**1.** A method comprising:

forming a first mirror layer on a substrate;
depositing a first set of spacer layers on the first mirror layer to be positioned above a first group of the sensing elements;
depositing a second set of spacer layers on the first mirror layer to be positioned above a second group of the sensing elements, wherein the second set of spacer layers differs from the first set; and
forming a second mirror layer above the deposited first set of spacer layers and the deposited second set of spacer layers.

**2.** The method according to claim 1, wherein forming the first mirror layer further comprises forming the first mirror layer to have tapered edges, said method further comprising:

depositing a plurality of the first set of spacer layers to cover the tapered edges of the first mirror layer.

**3.** The method according to claim 1 or claim 2, further comprising:

accessing a first center wavelength of light that is to be filtered for each of the sensing elements in the first group of sensing elements;
determining the first set of spacer layers that corresponds to the accessed first center wavelength of light that is to be filtered; and
wherein depositing the first set of spacer layers further comprises depositing the determined first set of spacer layers that corresponds to the accessed first center wavelength of light that is to be filtered.

**4.** The method according to claim 3, further comprising:

accessing a second center wavelength of light that is to be filtered for each of the sensing elements in the second group of sensing elements;
determining the second set of spacer layers that corresponds to the accessed second center wavelength of light that is to be filtered; and
wherein depositing the second set of spacer layers further comprises depositing the determined second set of spacer layers that corresponds to the accessed second center wavelength of light that is to be filtered.

**5.** The method according to claim 4, further comprising:

depositing a base spacer layer, and wherein depositing the first set of spacer layers and depositing the second set of spacer layers further comprises depositing the first set of spacer layers and depositing the second set of spacer layers on the deposited base spacer layer.

**6.** The method according to any one of the preceding claims, wherein depositing the first set of spacer layers and depositing the second set of spacer layers further comprise depositing at least one spacer layer that is common to both the first set of spacer layers and the second set of spacer layers.

**7.** The method according to claim 6, wherein depositing the first set of spacer layers and depositing the second set of spacer layers further comprise:

depositing the common spacer layer;
applying a mask over portions of the common spacer layer that are above the first group of the sensing elements; and
depositing another spacer layer, wherein the mask prevents the another spacer layer from being deposited over the first group of the sensing elements while enabling the another spacer layer to be deposited over the second group of the sensing elements.

8. The method according to any one of the preceding claims, further comprising:

    depositing an oxidization preventing material on the first mirror layer prior to depositing the first set of spacer layers and the second set of spacer layers on the first mirror layer, wherein the first mirror layer is formed of silver and the oxidization preventing material is zinc oxide.

9. The method according to claim 8, wherein the second group of the sensing elements includes half of the sensing elements of the first group of sensing elements.

10. A method comprising:

    forming a first mirror layer on a substrate having an array of sensing elements;
    depositing a base spacer layer over the first mirror layer;
    applying a first mask over a first group of the sensing elements;
    depositing a first spacer layer, wherein the first mask prevents the first spacer layer from being deposited on portions of the base spacer layer positioned over the first group of the sensing elements while enabling the first spacer layer to be deposited on portions of the base spacer layer positioned over the sensing elements other than the sensing elements in the first group;
    removing the first mask;
    applying a second mask over a second group of the sensing elements;
    depositing a second spacer layer, wherein the second mask prevents the second spacer layer from being deposited on portions of the base spacer layer positioned over the second group of the sensing elements while enabling the second spacer layer to be deposited on portions of the base spacer layer positioned over the sensing elements other than the sensing elements in the second group; and
    removing the second mask.

11. The method according to claim 10, further comprising:

    accessing a predetermined filter pattern for the array of sensing elements, and wherein applying the first mask, depositing the first spacer layer, applying the second mask, and depositing the second spacer layer further comprises applying the first mask, depositing the first spacer layer, applying the second mask, and depositing the second spacer layer to form the predetermined filter pattern.

12. The method according to claim 10 or claim 11, further comprising:

    forming a second mirror layer above the deposited first spacer layer and the deposited second spacer layer, wherein forming the first mirror layer and forming the second mirror layer further comprise forming the mirror layer and forming the second mirror layer with an element selected from the group consisting essentially of a dielectric material, a quarter-wave stack, and a metal.

13. The method according to any one of claims 10-12, wherein applying the second mask further comprises applying the second mask to leave at least a portion of the first spacer layer uncovered and wherein depositing the second spacer layer further comprises depositing the second spacer layer on the at least a portion of the first spacer layer that is uncovered.

14. The method according to any one of claims 10-13, further comprising:

    forming at least one of blockers and anti-reflective coatings above at least one collection of sensing elements, wherein the blockers are to block predetermined wavelengths of light.

15. A method comprising:

    forming a first mirror layer on a substrate having an array of sensing elements;
    depositing a base spacer layer over the first mirror layer;
    depositing a first spacer layer on the base spacer layer above a first subset of the sensing elements;

depositing a second spacer layer on at least one of the first spacer layer and the base spacer layer above a second subset of the sensing elements; and
forming a second mirror layer above the deposited first spacer layer and the deposited second spacer layer.

PHOTODIODE

FIG. 1

(PRIOR ART)

FIG. 2

(PRIOR ART)

FILTER + PHOTODIODE

FIG. 3
(PRIOR ART)

FILTER + PHOTODIODE

FIG. 4
(PRIOR ART)

FIG. 5
(PRIOR ART)

FIG. 6
(PRIOR ART)

FIG. 7A

FIG. 7B

200

102   106   108

104

*FIG. 8A*

200
CONT.

102   106   110   108

104

*FIG. 8B*

200
CONT.

112   202   108

202   202

102   104   110   106

*FIG. 8C*

200
CONT.

114 — 112 — 110 108

102 104 106

FIG. 8D

200
CONT.

114 116

112 108

102 104 110 106

FIG. 8E

250

116 114 110 106

112 108

252

254

102

104

FIG. 8F

FIG. 9A

FIG. 9B

102

104

112

114

202

110

108

## FIG. 10

300

302

106

116

110

112

114

120

122

## FIG. 11

2nd
COATING

| 8 | 8 | 0 | 0 |
| 8 | 8 | 0 | 0 |
| 8 | 8 | 0 | 0 |
| 8 | 8 | 0 | 0 |

2nd
COATING

| 0 | 0 | 0 | 0 |
| 0 | 0 | 0 | 0 |
| 8 | 8 | 8 | 8 |
| 8 | 8 | 8 | 8 |

3RD
COATING

| 0 | 4 | 4 | 0 |
| 0 | 4 | 4 | 0 |
| 0 | 4 | 4 | 0 |
| 0 | 4 | 4 | 0 |

3RD
COATING

| 0 | 0 | 0 | 0 |
| 4 | 4 | 4 | 4 |
| 0 | 0 | 0 | 0 |
| 4 | 4 | 4 | 4 |

4TH
COATING

| 2 | 2 | 2 | 2 |
| 2 | 2 | 2 | 2 |
| 0 | 0 | 0 | 0 |
| 0 | 0 | 0 | 0 |

4TH
COATING

| 0 | 0 | 2 | 2 |
| 0 | 0 | 2 | 2 |
| 0 | 0 | 2 | 2 |
| 0 | 0 | 2 | 2 |

5TH
COATING

| 0 | 0 | 0 | 0 |
| 1 | 1 | 1 | 1 |
| 1 | 1 | 1 | 1 |
| 0 | 0 | 0 | 0 |

5TH
COATING

| 0 | 1 | 0 | 1 |
| 0 | 1 | 0 | 1 |
| 0 | 1 | 0 | 1 |
| 0 | 1 | 0 | 1 |

COMBINED
SPACER
THICKNESS

| 10 | 14 | 6 | 2 |
| 11 | 15 | 7 | 3 |
| 9 | 13 | 5 | 1 |
| 8 | 12 | 4 | 0 |

COMBINED
SPACER
THICKNESS

| 0 | 1 | 2 | 3 |
| 4 | 5 | 6 | 7 |
| 8 | 9 | 10 | 11 |
| 12 | 13 | 14 | 15 |

*FIG. 12A*        *FIG. 12B*

2nd
COATING

| 0 | 0 | 0 | 0 | 0 | 0 | 0 | 0 | 8 | 8 | 8 | 8 | 8 | 8 | 8 | 8 |

3RD
COATING

| 0 | 0 | 0 | 0 | 4 | 4 | 4 | 4 | 0 | 0 | 0 | 0 | 4 | 4 | 4 | 4 |

4TH
COATING

| 0 | 0 | 2 | 2 | 0 | 0 | 2 | 2 | 0 | 0 | 2 | 2 | 0 | 0 | 2 | 2 |

5TH
COATING

| 0 | 1 | 0 | 1 | 0 | 1 | 0 | 1 | 0 | 1 | 0 | 1 | 0 | 1 | 0 | 1 |

COMBINED
SPACER
THICKNESS

| 0 | 1 | 2 | 3 | 4 | 5 | 6 | 7 | 8 | 9 | 10 | 11 | 12 | 13 | 14 | 15 |

*FIG. 12C*

**FIG. 13A**

**FIG. 13B**

FIG. 14

FIG. 15

<u>600</u>

## FIG. 16

<u>700</u>

## FIG. 17

Europäisches
Patentamt

European
Patent Office

Office européen
des brevets

## PARTIAL EUROPEAN SEARCH REPORT

under Rule 62a and/or 63 of the European Patent Convention.
This report shall be considered, for the purposes of
subsequent proceedings, as the European search report

Application Number

EP 17 15 4949

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 592 067 A1 (MATSUSHITA ELECTRIC IND CO LTD [JP]) 2 November 2005 (2005-11-02) * paragraphs [0055] - [0065]; figures 3, 4A-4E, 5A-5G, 8-11 * ----- | 1,3-7,9 | INV. H01L27/146 G01J1/04 |
| X | EP 2 746 739 A2 (JDS UNIPHASE CORP [US]) 25 June 2014 (2014-06-25) * paragraphs [0021], [0047] - [0054]; figures 1a-1g, 2, 8 * ----- | 1-6,8,9 | |
| A | US 2013/240708 A1 (KOKUBUN KOICHI [JP]) 19 September 2013 (2013-09-19) * paragraphs [0028], [0034], [0040], [0051] - [0057]; figures 1-6 * ----- | 1-9 | |

TECHNICAL FIELDS
SEARCHED (IPC)

H01L
G01J
G02B

### INCOMPLETE SEARCH

The Search Division considers that the present application, or one or more of its claims, does/do
not comply with the EPC so that only a partial search (R.62a, 63) has been carried out.

Claims searched completely :

Claims searched incompletely :

Claims not searched :

Reason for the limitation of the search:

see sheet C

| Place of search | Date of completion of the search | Examiner |
|---|---|---|
| The Hague | 18 October 2017 | Cabrita, Ana |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

 

& : member of the same patent family, corresponding
document

EPO FORM 1503 03.82 (P04E07)

Europäisches
Patentamt

European
Patent Office

Office européen
des brevets

**INCOMPLETE SEARCH
SHEET C**

Application Number

EP 17 15 4949

Claim(s) completely searchable:
       1-9

Claim(s) not searched:
       10-15

Reason for the limitation of the search:

In reply to the invitation to indicate the claims on which the search is
to be based, the applicant failed to supply the requested indication in
due time.
Thus, the search report has been drawn up on the basis of the first
independent claim of each category (Rule 62a(1) EPC):
claims 1-9
The applicant's attention is drawn to the fact that the application will
be further prosecuted on the basis of subject-matter for which a search
has been carried out and that the claims should be limited to that
subject-matter at a later stage of the proceedings (Rule 62a(2) EPC).

## ANNEX TO THE EUROPEAN SEARCH REPORT
## ON EUROPEAN PATENT APPLICATION NO.

EP 17 15 4949

This annex lists the patent family members relating to the patent documents cited in the above-mentioned European search report.
The members are as contained in the European Patent Office EDP file on
The European Patent Office is in no way liable for these particulars which are merely given for the purpose of information.

18-10-2017

| Patent document cited in search report | | | Publication date | Patent family member(s) | | | Publication date |
|---|---|---|---|---|---|---|---|
| EP | 1592067 | A1 | 02-11-2005 | EP | 1592067 | A1 | 02-11-2005 |
| | | | | JP | 4638356 | B2 | 23-02-2011 |
| | | | | JP | WO2005069376 | A1 | 26-07-2007 |
| | | | | KR | 20060008275 | A | 26-01-2006 |
| | | | | TW | 200524150 | A | 16-07-2005 |
| | | | | US | 2006205107 | A1 | 14-09-2006 |
| | | | | WO | 2005069376 | A1 | 28-07-2005 |
| EP | 2746739 | A2 | 25-06-2014 | CA | 2835712 | A1 | 19-06-2014 |
| | | | | CN | 103887318 | A | 25-06-2014 |
| | | | | EP | 2746739 | A2 | 25-06-2014 |
| | | | | HK | 1199144 | A1 | 19-06-2015 |
| | | | | KR | 20140079726 | A | 27-06-2014 |
| | | | | TW | 201432893 | A | 16-08-2014 |
| | | | | US | 2014168761 | A1 | 19-06-2014 |
| | | | | US | 2017068025 | A1 | 09-03-2017 |
| US | 2013240708 | A1 | 19-09-2013 | JP | 5710526 | B2 | 30-04-2015 |
| | | | | JP | 2013191717 | A | 26-09-2013 |
| | | | | US | 2013240708 | A1 | 19-09-2013 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **LAPRAY et al.** Multispectral Filter Arrays: Recent Advances and Practical Implementation. *Sensors,* 2014, vol. 14, 21626-21659